# EUROPEAN PATENT APPLICATION

(11) **EP 2 383 774 A1**
(43) Date of publication of application: **02.11.2011**
(21) Application number: 10735850.9
(22) Date of filing: 28.01.2010
(51) Int. Cl.: H01L 21/31, C23C 16/455

(54) **FILM DEPOSITION DEVICE AND GAS EJECTION MEMBER**

(30) Priority: 29.01.2009 JP 2009018365
(71) Applicant: Tokyo Electron Limited, Tokyo 107-6325 (JP)
(72) Inventor: IWATA Teruo, Nirasaki-shi Yamanashi 407-0192 (JP); KUWAJIMA Ryo, Nirasaki-shi Yamanashi 407-0192 (JP); AMIKURA Manabu, Nirasaki-shi Yamanashi 407-0192 (JP); HASHIMOTO Tsuyoshi, Nirasaki-shi Yamanashi 407-0192 (JP); UCHIDA Hiroaki, Nirasaki-shi Yamanashi 407-0192 (JP)
(74) Representative: HOFFMANN EITLE
(86) International application number: PCT/JP2010/051090
(87) International publication number: WO 2010/087385

(57) **Abstract**

A film forming apparatus includes: a chamber for holding a wafer; a susceptor on which the wafer is placed within the chamber; heaters which heat the wafer placed on the susceptor; and a shower plate disposed opposite to the susceptor to inject a film formation processing gas toward the wafer, a main body of the shower plate being made of aluminum or an aluminum alloy. With the apparatus, a film is deposited on the surface of the wafer, the film having a low thermal expansion coefficient, measured at the film deposition temperature, lower by at least about 5×10⁻⁶/°C than a thermal expansion coefficient of the main body of the shower plate. The shower plate has an anodized film having a thickness of 10 µm or thicker formed on the side of the main body facing the susceptor.

## Description

### Field of the Invention

The present invention relates to a film forming apparatus for forming a film such as a high-k film or the like on a substrate to be processed by having a processing gas injected through a gas injection member to react thereon, and the gas injection member used therefor.

### Background of the Invention

Recently, with the trend of requirement for high integration and high speed of LSI (large scale integrated circuit), a design rule of semiconductor devices forming the LSI becomes finer. Thus, EOT (equivalent oxide (SiO₂) thickness) of a gate dielectric in a CMOS device is required to be about 1.5 nm or less. As for a material for realizing such a thin dielectric without increasing a gate leakage current, a high dielectric constant material, a so-called high-k material, has drawn attention.

When a high-k material is used for a gate dielectric, the high-k material and a silicon substrate are required not to diffuse into each other, and to be thermodynamically stable. Hence, a hafnium, a zirconium, or a lanthanum based oxide, or a silicate thereof is considered as a promising high-k material.

Meanwhile, without being limited to forming a film with such high-k material, a film forming apparatus includes a mounting table for mounting thereon a semiconductor wafer as a substrate to be processed in a chamber and a shower plate, having a plurality of gas injection openings and serving as a gas injection member, disposed to face the mounting table. This film forming apparatus forms a predetermined film on the surface of the substrate by having a film formation processing gas to react on the substrate, the processing gas being injected through the gas injection openings of the shower plate while the semiconductor wafer on the mounting table is heated.

In this film forming apparatus, the shower plate is generally made of aluminum or aluminum alloy. Further, in order to control emissivity and improve corrosion resistance, a thin anodized film (alumite coating film) is formed on the surface of the shower plate which faces the substrate to be processed (see, e.g., Japanese Patent Application Publication No. 2000-303180).

However, when a film made of a high-k material such as hafnium oxide or the like (high-k film) is formed by the above-described film forming apparatus, the film is also formed on the surface of the shower plate during the film formation. As the film formation is repeatedly performed on the wafer, cracks are generated on the film formed on the shower plate, and the film is peeled off or separated in some cases. In addition, the repeatability of the film thickness on the wafer and the stability of the in-plane film thickness distribution are decreased, and the number of particles on the wafer tends to be increased.

### Summary of the Intention

In view of the above, the present invention provides a film forming apparatus which prevents cracks, peeling-off and separation of a film formed on a gas injection member during film formation, and the gas injection member used therefor.

In order to solve the above drawbacks, the present inventors have performed extensive examinations and have found that when a conventional gas injection member made of aluminum or aluminum alloy is used, a thermal expansion coefficient of a high-k film such as the hafnium oxide film which is measured at a processing temperature is considerably different from that of the main body of the gas injection member, and the high-k film adhered to the gas injection member during the film formation is easily peeled off due to the difference in the thermal expansion between itself and the main body during the film formation. Furthermore, the present inventors have found that the peeling-off occurs not only when the high-k film is used but also when the difference in the thermal expansion coefficient measured at a film forming temperature between the gas injection member and a film to be formed is about 5×10⁻⁶/°C or above.

Therefore, it is effective to use a gas injection member having a thermal expansion coefficient that differs no more than about 5×10⁻⁶/°C from that of a film to be formed. However, the present inventors have found that even when the difference in the thermal expansion coefficient between the gas injection member and the film is about 5×10⁻⁶/°C or above, the difference in the thermal expansion between the gas injection member and the film formed thereon can be decreased by previously forming an oxide film having a thickness about 10 µm or above on the surface of the gas injection member whose thermal expansion coefficient differs no more than about 5×10⁻⁶/°C from that of the film to be formed on the surface of the gas injection member. For example, when a conventional gas injection member made of, e.g., aluminum or aluminum alloy is used, the difference in the thermal expansion between the gas injection member and the film formed thereon can be decreased by previously forming an anodized film having a thickness of about 10 µm or above on the surface of the gas injection member.

Moreover, when an emissivity of the gas injection member is smaller than that of the film formed thereon, the emissivity of the gas injection member is gradually changed as the film formation on the gas injection member proceeds. The change of the emissivity leads to an increase of the radiant heat input to the gas injection member and, thus, the temperature of the gas injection member is increased. However, if the temperature is excessively increased, stress is generated in the film due to the thermal expansion difference between the gas injection member and the film formed thereon, which may result in cracks.

The present invention has been conceived by the above conclusion.

### Brief Description of the Drawings

Fig. 1 is a cross sectional view showing a film forming apparatus in accordance with an embodiment of the present invention.
Fig. 2 is a cross sectional view showing a shower plate of the film forming apparatus of Fig. 1.
Fig. 3 illustrates film thickness changes in an HfSiOₓ film on a wafer and variation of the film thickness changes in a case of continuously forming an HfSiOₓ film on 10000 wafers by using a film forming apparatus including a shower plate having an anodized oxide film having a thickness of about 20 µm.
Fig. 4 illustrates the number of particles whose sizes are larger than about 0.12 µm on every twentieth wafer which was sampled in the case of continuously forming an HfSiOₓ film on 10000 wafers by using a film forming apparatus including a shower plate having an anodized oxide film having a thickness of about 20 µm.
Fig. 5 illustrates temperature changes in a shower head and a shower plate in the case of continuously forming an HfSiOₓ film on 10000 wafers by using a film forming apparatus including a shower plate having an anodized oxide film having a thickness of about 20 µm.
Fig. 6A provides an image showing a result of a peel test performed on a surface of a shower plate in the case of continuously forming an HfSiOₓ film on 10000 wafers by using a film forming apparatus including a shower plate having an anodized oxide film having a thickness of about 20 µm.
Fig. 6B provides an image showing a result of a peel test performed on a surface of a shower plate in the case of continuously forming an HfO₂ film on 10000 wafers by using a conventional film forming apparatus including a shower plate having an anodized oxide film having a thickness of about 0.7 µm.
Fig. 6C provides an image showing a result of a peel test performed on a surface of a shower plate in the case of continuously forming an HfSiOₓ film on 10000 wafers by using a conventional film forming apparatus including a shower plate having an anodized oxide film having a thickness of about 0.7 µm.
Fig. 7 provides a scanning electron microscope (SEM) image showing a cross section of a shower plate which is obtained after continuously forming an HfSiOₓ film on 10000 wafers by using a film forming apparatus including a shower plate having an anodized oxide film having a thickness of about 20 µm.
Fig. 8 provides an SEM image showing a cross section of a shower plate which is obtained after continuously forming an HfSiOₓ film on 10000 wafers by using a film forming apparatus including a shower plate having an anodized oxide film having a thickness of about 0.7 µm.
Fig. 9 illustrates temperature changes in a shower plate in the case of continuously forming an HfO₂ film on 5000 wafers by using a conventional shower plate made of aluminum.
Fig. 10 compares temperature changes in a shower plate between in the case of continuously forming an HfSiOₓ film on 10000 wafers by using a conventional shower plate made of aluminum and in the case of continuously forming an HfSiOₓ film on 10000 wafers by using a shower plate having an anodized oxide film formed thereon.
Fig. 11 schematically shows temperature changes in a shower plate in the case of continuously forming an HfSiOₓ film by using a shower plate having an anodized oxide film formed thereon.
Fig. 12 schematically shows states of a shower plate under the conditions A to C of Fig. 13.
Fig. 13 illustrates a result of examining conditions that result in a 'film thickness decrease' in which a film thickness obtained in the case of continuously forming an HfSiOₓ film (Si 30%) on 5000 wafers becomes smaller than a standard.
Fig. 14 is a cross sectional view showing a shower plate of a film forming apparatus in accordance with a second embodiment of the present invention.
Fig. 15 is a cross sectional view showing a shower plate of a film forming apparatus in accordance with a third embodiment of the present invention.
Fig. 16 illustrates film thickness changes in an HfSiOₓ film on a wafer and variation in the film thickness changes in the case of continuously forming an HfSiOₓ film on 5000 wafers or more by using a film forming apparatus including a shower plate in which a TiO₂ film is formed on a Ti plate.

### Detailed Description of the Embodiments

The embodiments of the present invention will now be described with reference to the accompanying drawings which form a part hereof.

### (First Embodiment)

First of all, a first embodiment of the present invention will be described.

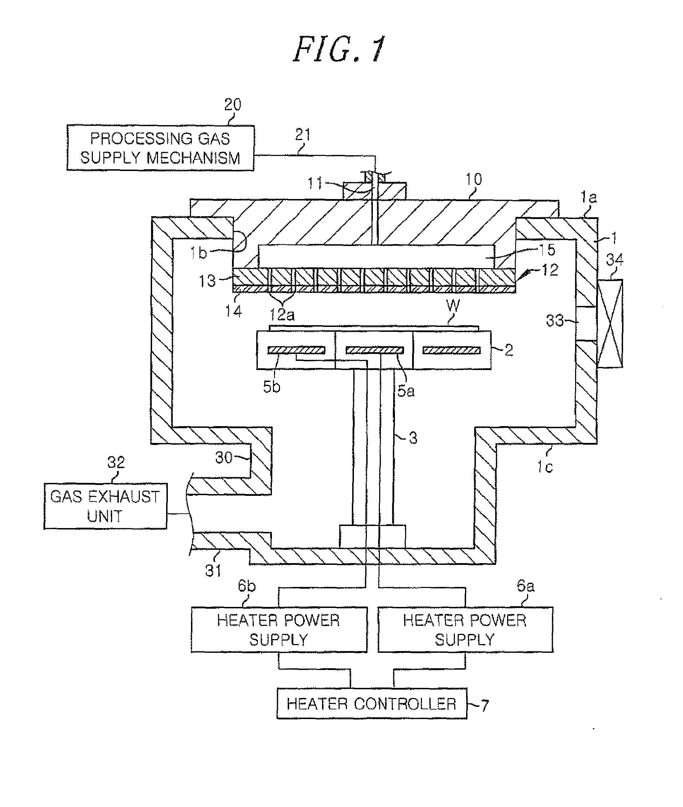

Fig. 1 is a cross sectional view showing a film forming apparatus in accordance with the first embodiment of the present invention. This film forming apparatus 100 includes a substantially cylindrical airtight chamber 1, and a susceptor for horizontally supporting a semiconductor wafer (hereinafter, simply referred to as "wafer") as a substrate to be processed is supported by a cylindrical supporting member 3 provided at the center of the bottom portion of the chamber 1. The susceptor 2 is made of ceramic such as AlN or the like. Further, heaters 5a and 5b are buried in the susceptor 2. The heater 5a is provided at the central portion of the susceptor, and the heater 5b is provided in a doughnut-shape at the outer side of the heater 5a. The heaters 5a and 5b are respectively connected to heater power supplies 6a and 6b. The heater power supplies 6a and 6b are independently controlled by a heater controller 7 based on a detection signal from a thermocouple (not shown) provided at the susceptor 2, so that the temperature of the wafer W is controlled.

A circular opening 1b is formed at a ceiling wall 1a of the chamber 1, and a shower head 10 is fitted into the opening 1b and protrudes into the chamber 1. The shower head 10 is made of aluminum or aluminum alloy. A gas inlet port 11 is provided at a top surface of the shower head 10, and a circular plate-shaped recess is formed at a bottom portion of the shower head 10. A shower plate 12 serving as a gas injection member is attached to the bottom portion of the shower head 10 so as to cover the recess, and a space formed by the recess and the shower plate 12 serves as a gas diffusion space 15. Further, when a film is formed by reaction of two or more processing gases, there may be used a post-mix type shower head 10 in which the gases are mixed with each other after being injected from the shower plate 12 via separate routes.

The gas inlet port 11 of the shower head 10 is connected to a gas supply line 21 extending from a processing gas supply mechanism 20.

The processing gas supply mechanism 20 supplies to the chamber 1 a processing gas for forming a predetermined film on the wafer W on the susceptor 2. In the present embodiment, a film having a thermal expansion coefficient, measured at a film formation temperature, lower by at least about 5×10⁻⁶/°C than that of a material forming a main body 13 of the shower plate 12 is formed. Typically, a high-k film is formed. Among high-k films, it is preferable to form an HfO₂ film or an HfSiOₓ film (x being 1 or 2). In addition, a zirconium oxide (ZrOₓ) film, a zirconium silicate (ZrSiOₓ) film, a lanthanum oxide (LaOₓ) film, a lanthanum silicate (LaSiOₓ) film, a tantalum oxide (TaOₓ) film, a titanic acid strontium (SrTiOₓ) film, a yttrium oxide (YOₓ) film, and a titanium oxide (TiOₓ) film may be formed. These films are formed by supplying as process gases, e.g., an organic metal compound and an oxidizing agent or a silicon compound for forming a silicate when necessary, from the processing gas supply mechanism 20 to the wafer W through the shower plate 12 via the gas supply line 21 and the gas diffusion space 15. For example, when an HfO₂ film is formed, it is possible to use, as an organic metal compound, a metal alkoxide such as hafnium tetra-tert-butoxide (HTB) or the like, or an amine-based organic metal compound such as tetrakis (dimethylamino) hafnium (TDMAH) or the like. Further, O₃ gas, H₂O gas, O₂ gas or the like can be used as the oxidizing agent. Moreover, a silane-based compound such as tetra-ethoxy-silane (TEOS), disilane (Si₂H₆) or the like can be used as the silicon compound.

A gas exhaust chamber 30 is provided at a bottom wall 1c of the chamber 1 and protrudes downward. A gas exhaust line 31 is connected to a side surface of the gas exhaust chamber 30, and a gas exhaust unit 32 is connected to the gas exhaust line 31. By operating the gas exhaust unit 32, the chamber 1 can be depressurized to a predetermined vacuum level.

Formed on a sidewall of the chamber 1 are a loading/unloading port 33 for loading and unloading a wafer W with respect to a wafer transfer chamber (not shown) and a gate valve 34 for opening and closing the loading/unloading port 33.

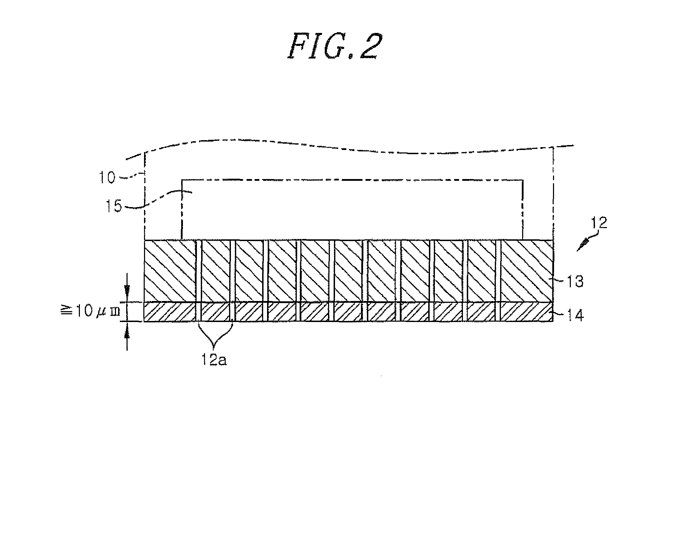

As shown in Fig. 2, the shower plate 12 includes the main body 13 made of aluminum or aluminum alloy having a thermal expansion coefficient, measured at a film forming temperature, higher by at least about 5×10⁻⁶/°C than that of the film to be formed, and an anodized film (Al₂O₃) 14 formed on the bottom surface of the main body 13. The shower plate 12 has a plurality of gas injection openings 12a. The anodized film 14 functions to reduce the difference in the thermal expansion between the main body 13 made of aluminum or aluminum alloy which has a high thermal expansion coefficient and the film adhered to the surface of the shower plate 12 during the film formation. In other words, the same film as that formed on the wafer W is adhered to the surface of the shower plate 12, so that a large thermal expansion coefficient difference exists between the adhered film and the main body 13. Therefore, when this film is directly adhered to the main body 13, it may be peeled off due to the thermal expansion difference by heating during the film formation. However, if the anodized film 14 is formed on the bottom surface of the main body 13, the thermal expansion difference therebetween can be reduced, thereby suppressing the peeling off of the adhered film.

In order to reduce the thermal expansion difference, the anodized film 14 needs to have a thickness larger than or equal to about 10 µm. When the anodized film 14 is smaller than about 10 µm, the thermal expansion thereof is increased by the effect of the thermal expansion of the main body 13, which makes it difficult to sufficiently reduce the thermal expansion difference. Preferably, the anodized film 14 has a thickness larger than or equal to about 15 µm. In view of reducing the thermal expansion difference, the film thickness of the anodized film 14 does not have an upper limit. However, even when the film thickness exceeds about 100 µm, the effect is saturated and the cost is increased. Thus, the actual upper limit of the film thickness is about 100 µm.

In the film forming apparatus configured as described above, first of all, the chamber 1 is depressurized to a predetermined pressure, e.g., about 400 Pa. Then, the wafer W is heated to a predetermined temperature by the heaters 5a and 5b. The heating temperature is set to a temperature within a range from about 200 °C to about 600 °C when a film to be formed is either an HfO₂ film or an HfSiOₓ film.

In this state, a film formation processing gas is supplied from the processing gas supply mechanism 20 toward the wafer W through the gas injection openings 12a of the shower plate 12 via the gas supply line 21 and the gas diffusion space 15. As a consequence, the processing gas reacts on the pre-heated wafer W, and a high-k film, e.g., an HfO₂ film or an HfSiOₓ film, is formed on the surface of the wafer W. Then, the film formation is continuously performed on a plurality of wafers W.

During the film formation, the film formation reaction also occurs on the surface of the shower plate 12. Thus, the film to be formed is adhered to the surface of the shower plate 12. When the film formation is continuously performed on a plurality of wafers W, the amount of the film deposited on the surface of the shower plate 12 is increased.

In the conventional shower plate 12, an anodized film having a thin thickness of about 0.7 µm is formed on the surface thereof. Hence, the anodized film is thermally expanded by substantially the same amount as that of the main body made of aluminum or aluminum alloy. For example, when the main body of the shower plate is made of aluminum, and a film to be formed is an HfO₂ film or an HfSiOₓ film, the thermal expansion coefficient difference between aluminum having a thermal expansion coefficient of about 23×10⁻⁶/°C and HfO₂ or HfSiOₓ having a thermal expansion coefficient ranging from about 5 to about 8×10⁻⁶/°C ranges from about 15×10⁻⁶/°C to about 18×10⁻⁶/°C. Therefore, the film adhered to the shower plate 12 is easily peeled off. If this film is peeled off, the number of particles on the wafer W is increased, and an area of the surface of the shower head 12 is increased. Accordingly, a large amount of the processing gas for film formation is consumed at the shower plate 12, and the amount of the processing gas supplied to the wafer W is decreased. As a result, the film thickness repeatability of the film on the wafer or the stability of the in-plane film thickness distribution becomes poor.

On the other hand, in the present embodiment, an anodized film having a thickness larger than or equal to about 10 µm is formed on the surface of the main body 13 of the shower plate 12, so that the thermal expansion difference is reduced and the peeling off of the film adhered to the shower plate is suppressed. That is, since the anodized film 14 is, e.g., Al₂O₃, having a thermal expansion coefficient ranging from about 6×10⁻⁶/°C to about 8×10⁻⁶/°C and a thickness larger than or equal to about 10 µm, a thermal expansion coefficient of a portion where the anodized film 14 is in contact with the adhered film is close to a value ranging from about 6×10⁻⁶/°C to about 8×10⁻⁶/°C. Hence, the thermal expansion difference hardly exists between the anodized film 14 and the adhered film, and the peeling off of the adhered film can be sufficiently suppressed. As a result, the number of particles on the wafer can be maintained at a low level, and the film thickness repeatability of the film on the wafer and the stability of the in-plane film thickness distribution can be improved.

The peeling off of the film tends to easily occur when the thermal expansion difference between the main body 13 of the shower plate 12 and the film to be formed is about 5×10⁻⁶/°C or above. The film to be formed has a low thermal expansion coefficient, measured at a film forming temperature, lower by at least about 5×10⁻⁶/°C than that of the material forming the main body 13. The same tendency is applied to the aforementioned materials such as hafnium silicate (HfSiOₓ), lanthanum oxide (LaOₓ), titanium oxide (TiOₓ), tantalum oxide (TaOₓ) or the like. In addition, the material having a thermal expansion coefficient in the above-described range may be a ZrOₓ film, a ZrSiOₓ film, a LaSiOₓ film, a SrTiOₓ film, a YOₓ film or the like.

Although a large thermal expansion difference exists between the main body 13 and the anodized film 14, the peeling or the like does not occur due to tight bonding therebetween.

As described above, in accordance with the present embodiment, the shower plate serving as a gas injection member is configured by forming an anodized film having a thickness larger than or equal to about 10 µm on the surface of the main body made of aluminum or aluminum alloy. Therefore, when forming a film having a thermal expansion coefficient lower by at least about 5×10⁻⁶/°C than that of the main body of the gas injecting member, the thermal expansion difference between the main body of the gas injection member and the film adhered to the surface of the gas injection member can be reduced. Besides, it is possible to suppress cracks, peeling off and separation of the film adhered to the gas injection member. Accordingly, the peeling off or the separation of the film formed on the surface of the gas injection member can be suppressed. Moreover, the film thickness repeatability of the film on the substrate and the stability of the in-plane film thickness distribution can be improved. Furthermore, the number of particles on the wafer can be reduced.

Although an anodized film is formed on a surface of a conventional shower plate serving as a gas injection member, the anodized film is formed in order to control emissivity and improve corrosion resistance as described above. Since the anodized film generally has a thin thickness of, e.g., about 0.7 µm, the effect of suppressing thermal expansion is hardly realized.

In the present embodiment, the anodized film 14 preferably has an emissivity of about 0.6 or above. When the anodized film 14 has a high emissivity, heat from the susceptor 2 is easily absorbed therein, and the temperature of the anodized film 14 is increased. Thus, the film adhered to the anodized film 14 becomes denser and is not easily peeled off. The emissivity of the anodized film 14 can be increased by increasing the surface roughness thereof. The emissivity of about 0.8 or above can be obtained by setting a surface roughness Ra (ISO4287-1997) of the anodized film 14 to be about 3.2 or above.

Hereinafter, the result of the test that has examined the effects of the present embodiment will be described.

The formation of an HfO₂ film was continuously performed on 10000 wafers while using HTB as a film formation processing gas by a film forming apparatus including a shower plate having an anodized film having a thickness of about 20 µm formed on a surface of a main body made of aluminum.

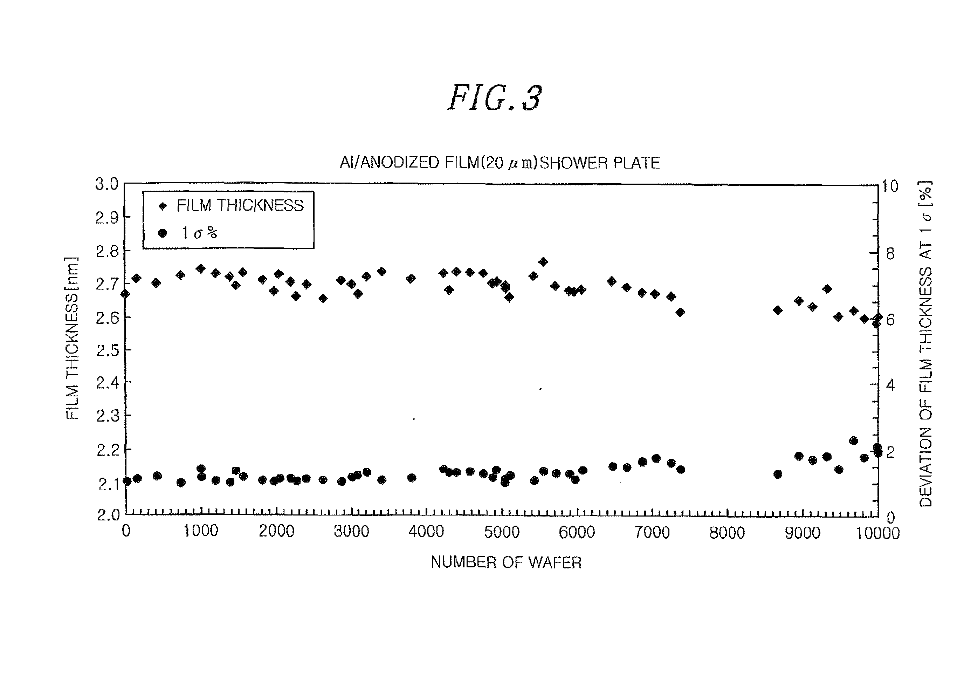

First of all, the film thickness changes in the HfSiOₓ film on the wafer and the variation of the film thickness changes in the case of continuously performing film formation on 10000 wafers were examined. The result thereof is shown in Fig. 3. Fig. 3 illustrates the film thickness changes in the HfSiOₓ film on the wafer and the variation of the film thickness changes in the case of continuously forming an HfSiOₓ film on 10000 wafers. As shown in Fig. 3, the film thicknesses were stable, and the deviations in the film thickness of 7000 and 10000 wafers were respectively about 0.94 % at 1σ and about 1.60 % at 1σ, which were tolerable.

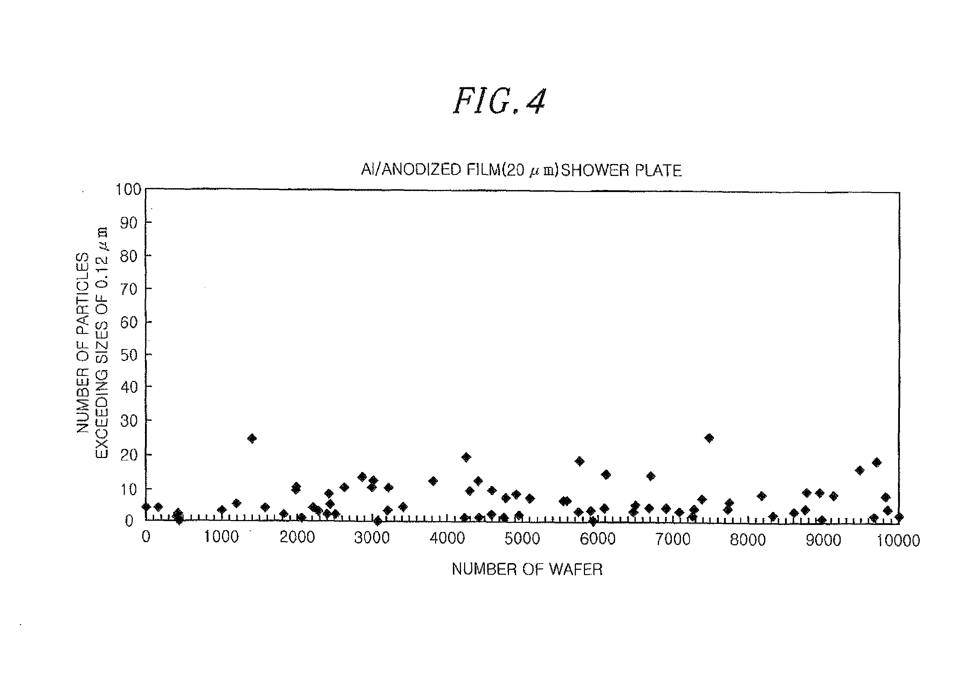

Next, the adhesion of particles on the wafer in the case of continuously performing film formation on 10000 wafers was examined. The result thereof is shown in Fig. 4. Fig. 4 illustrates the number of particles whose sizes were larger than about 0.12 µm on every twentieth wafer that was sampled. As shown in Fig. 4, the number of particles larger than about 0.12 µm was extremely small.

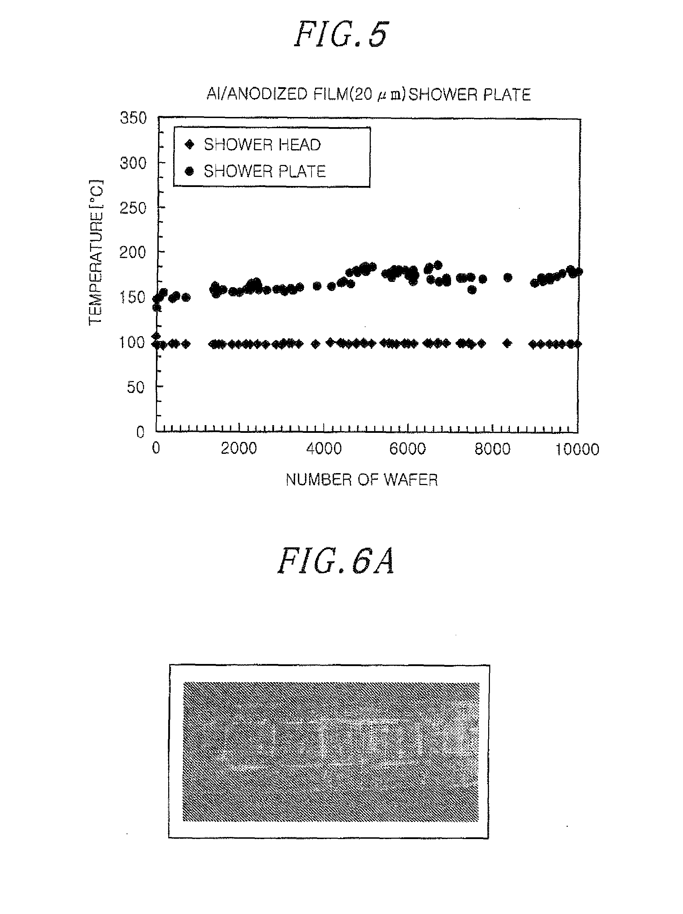

Thereafter, the stability of the temperature changes in the shower head and the shower plate in the case of continuous performing film formation on 10000 wafers was examined. The result thereof is shown in Fig. 5. Fig. 5 illustrates the temperature changes in the shower head and the shower plate in the case of performing continuous film formation on 10000 wafers. As shown in Fig. 5, the temperature of the shower head was not changed, whereas the temperature of the shower plate was gradually increased. This is because the emissivity of the anodized film of the shower plate was high, about 0.6 or above.

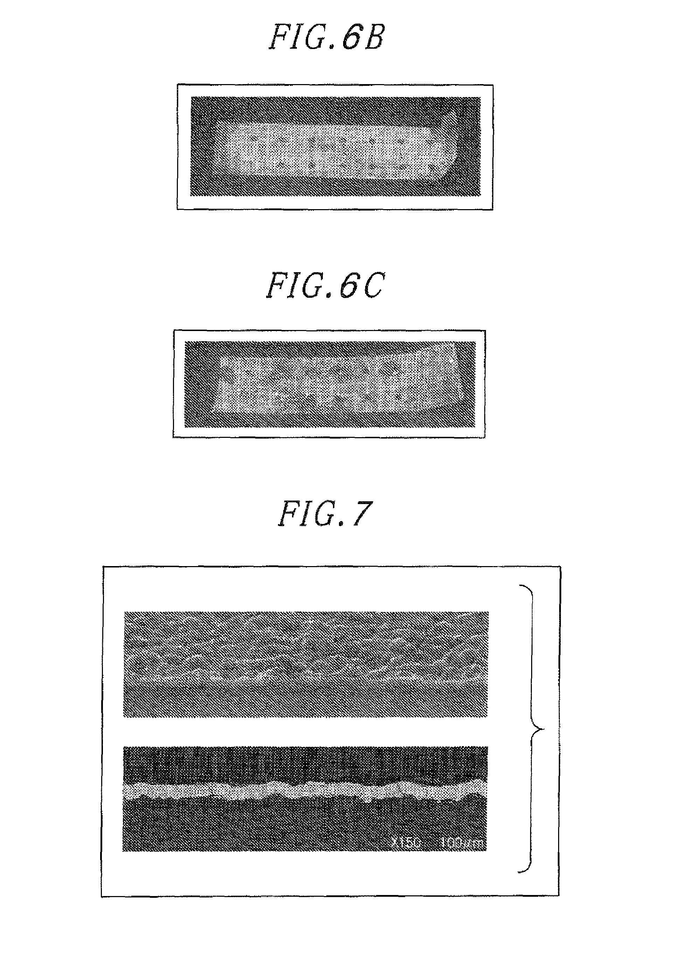

Next, the peel off test was performed on the shower plate after continuously forming an HfSiOₓ film on 10000 wafers by using a shower plate including an anodized film having a thickness of about 20 µm. For comparison, the peel off test was performed on the shower plate after continuously forming an HfO₂ film and an HfSiOₓ film on 10000 wafers by using a conventional shower plate including an anodized film having a thickness of about 0.7 µm. The peel off test was carried out by adhering a tape on the surface of the shower plate after completion of the film formation on the 10000 wafers, separating the tape therefrom, and examining deposits adhered to the tape with naked eyes. The results thereof are shown in Figs. 6A to 6C. Figs. 6A to 6C provide images showing the adhesion state of the deposits on the tape after the peel off test. Fig. 6A shows the result of continuously forming an HfSiOₓ film by using a shower plate of the present embodiment which had an anodized film having a thickness of about 20 µm. Figs. 6B and 6C shows the results of continuously forming the HfO₂ film and the HfSiOₓ film by using the conventional shower plate. As can be seen from these images, when a shower plate having a thick anodized film is used as in the present invention, the film adhered to the surface of the shower plate is hardly peeled off.

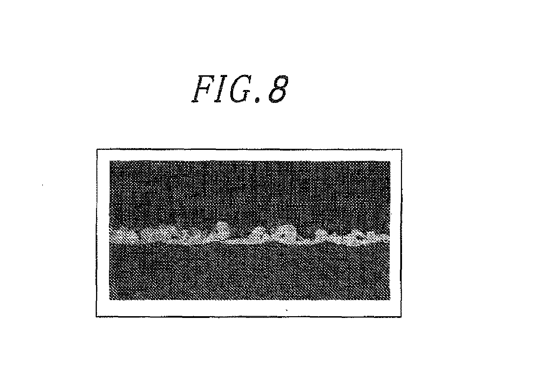

Thereafter, an HfSiOₓ film was continuously formed on 10000 wafers by using the shower plate having an anodized film having a thickness of about 20 µm and, then, the adhesion state of the HfSiOₓ film on the surface of the shower plate was examined. The result thereof is shown in Fig. 7. Fig. 7 provides an SEM image showing a cross section of the shower plate after continuously performing film formation on 10000 wafers. As illustrated in Fig. 7, the HfSiOₓ film formed on the shower plate was not peeled off. Although cracks were generated, it is considered that the cracks were caused by the rapid temperature change occurred when the shower plate was separated. For comparison, Fig. 8 provides an SEM image showing a cross section of a shower plate after continuously forming an HfSiOₓ film on 10000 wafers by using a conventional shower plate having an anodized film having a thickness of about 0.7 µm. As can be seen from Fig. 8, the peeling off of the HfSiOₓ film occurred in the conventional shower plate.

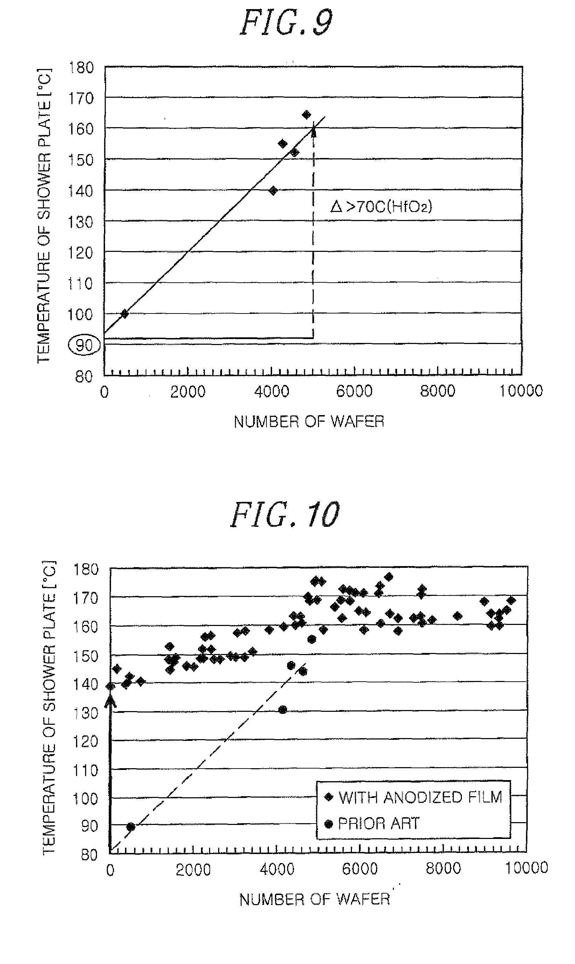

Since, however, the conventional shower plate has an extremely thin anodized film, the emissivity of the shower plate is about 0.05 which is substantially the same as that of aluminum. Meanwhile, when a film to be formed is the HfO₂ film or the HfSiOₓ film, it has a high emissivity of about 0.9. When the film formation is continuously performed on a plurality of wafers, the emissivity of the surface of the shower plate is gradually increased. As the adhesion of the HfO₂ film or the HfSiOₓ film to the shower plate proceeds, the radiant heat input to the shower plate is increased, and the temperature thereof is increased. Fig. 9 shows the temperature increase in the conventional shower plate in the case of forming an HfO₂ film. As shown in Fig. 9, the temperature of the shower plate was increased by about 70 °C or above as a result of continuous film formation performed on the 5000 wafers. That is, it is considered that the generation of cracks or the peeling off of the HfSiOₓ film or the HfO₂ film adhered to the shower plate due to the thermal expansion difference is aggravated when the temperature of the shower plate is changed by the change in the emissivity thereof.

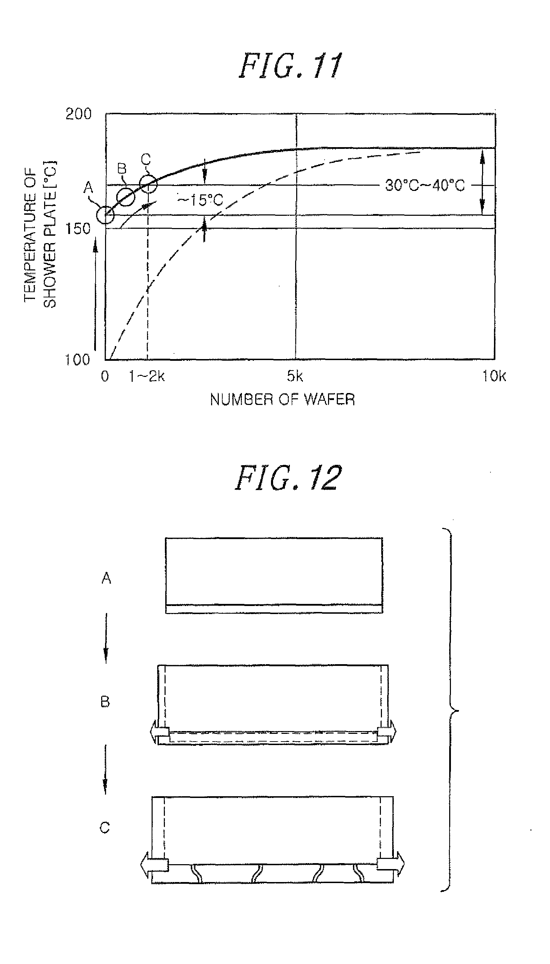

On the other hand, in the present embodiment, the emissivity of the surface of the shower plate 12 can be increased compared to the conventional case by using the shower plate 12 in which the anodized film 14 is formed on the surface of the main body 13. When the emissivity of the anodized film 14 is about 0.8, it is possible to increase the initial temperature compared to the conventional thin oxidized coating film, thereby reducing the temperature change of the shower plate, as can be seen from in Fig. 10. In view of the above, when the emissivity of the adhered film is about 0.9, the emissivity of the anodized film 14 is preferably about 0.8 or above. That is, the emissivity difference between the anodized film 14 and the adhered film is preferably about 0.1 or less. When an HfSiOₓ having an emissivity of about 0.9 is adhered to the anodized film 14 having an emissivity of about 0.8 as shown in Fig. 10, the emissivity difference is about 0.1. However, the radiant heat input to the shower plate 12 is increased as the film formation is continuously performed on a plurality of wafers, and the temperature of the shower plate 12 is gradually increased. The temperature of the shower plate 12 is increased by about 15°C from the initial temperature after the continuous film formation is performed on about 2000 wafers, and is increased by about 30°C from the initial temperature after the continuous film formation is performed on about 5000 wafers. Accordingly, the thermal expansion difference caused by the temperature difference cannot be ignored. In that case, stress is generated in the adhered HfSiOₓ film. That is, as can be seen from Fig. 11 schematically showing the temperature changes caused by the emissivity difference at this time, stress is hardly generated in the HfSiOₓ film adhered to the shower plate in an initial stage A shown in Fig. 12A. However, in a stage B, the number of processed wafers is increased and, thus, tensile stress is generated in the HfSiOₓ film as shown in Fig. 12B. In a stage C, the number of processed wafers becomes about 1000 to 2000, and the HfSiOₓ film cannot endure the tensile stress as shown in Fig. 12C. As a consequence, cracks are generated on the HfSiOₓ film. When the cracks are generated at the HSifOx film adhered to the shower plate, the film forming source of the HSifOx gas is consumed in the cracks during the film formation and, thus, the changes in film thickness and the distribution of the in-plane film thickness tend to be increased.

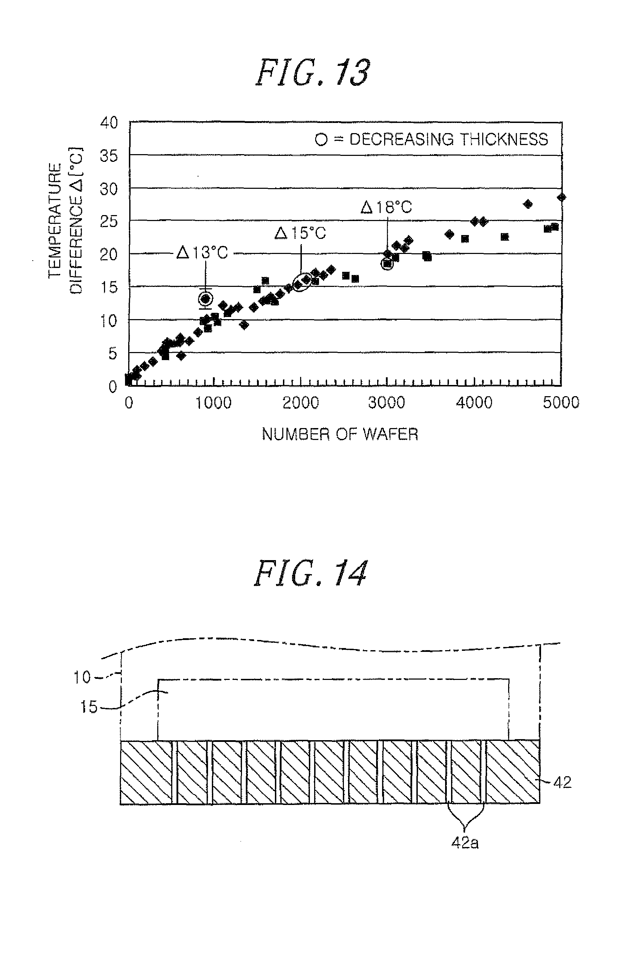

The conditions in which the film thickness varies are shown in Fig. 13. Fig. 13 shows the result of examining conditions for occurrence of a "film thickness decrease" in which a film thickness obtained in the case of continuously forming an HfSiOₓ film (Si 30%) on 5000 wafers becomes smaller than the standard. At this time, two cases (first case and second case) of using the shower plate having an anodized film (thickness 20 µm) are illustrated. For comparison, the state obtained when an HfSiOₓ (Si 30%) film is continuously formed on 1000 wafers by using a conventional shower plate made of aluminum is also illustrated. As shown in Fig. 13, even when the anodized film is formed, the "film thickness decrease" occurs at the temperature difference of about 13 °C or above. In the conventional shower plate made of aluminum, the "film thickness decrease" occurs when the film formation is continuously performed on about 1000 wafers.

Most of the drawbacks caused by the emissivity difference can be solved when the emissivity difference between the anodized film 13 and an adhered film, i.e., a film to be formed, is about 0.09 or less. When the adhered film is an HSifOx film or an HfO₂ film having an emissivity of about 0.9, the emissivity of the anodized film 14 ranges from preferably about 0.81 to about 0.99. To do so, the surface roughness Ra of the anodized film is set to be about 3.2 or above. More preferably, the emissivity difference is about 0.05 or less (i.e., when the adhered film is an HSifOₓ film or an HfO₂ film, the emissivity of the anodized film 14 is about 0.85 to 0.95).

The present embodiment has described the case in which an anodized film (Al₂O₃) is formed on the main body made of aluminum or aluminum alloy. However, the present invention is not limited thereto, and can also be applied to another case in which a main body and a film to be formed has a thermal expansion coefficient difference of about 5×10⁻⁶/°C or above; a film made of an oxide of the main body material is formed on the surface of the main body; and the oxide film and a film to be formed has a thermal expansion coefficient difference of about 5×10⁻⁶/°C or less. For example, when an HfSiOₓ film or an HfO₂ film is formed, a high-melting point metal such as Ti, Mo, Ta, W or the like can be used as a material forming the main body. Further, although the formation of a high-k film represented by an HfSiOₓ film or an HfO₂ film has been described in the present embodiment, the present invention is not limited to the formation of the high-k film, and can also be applied to the formation of another film having a low thermal expansion coefficient, measured at a film forming temperature, lower by at least about 5×10⁻⁶/°C than that of the main body of the gas injection member. In addition, the configuration of the apparatus can be variously modified without being limited to one described in the above embodiment.

### (Second Embodiment)

Hereinafter, a second embodiment of the present invention will be described.

Fig. 14 is a cross sectional view showing a shower plate of a film forming apparatus in accordance with a second embodiment of the present invention. The second embodiment has the configuration same as that of the first embodiment, so that the description thereof will be omitted.

The film forming apparatus of the present embodiment forms a high-k film such as an HfO₂ film or an HfSiO film. A shower plate 42 is made of a material having a thermal expansion coefficient, which differs, measured at a film forming temperature, no more than about 5×10⁻⁶/°C from that of a high-k film to be formed, and has a plurality of gas injection openings 42a.

Since a high-k film such as an HfO₂ film or an HfSiO film has a thermal expansion coefficient ranging from about 5×10⁻⁶/°C to about 8×10⁻⁶/°C, it is preferable to use, as a material of the shower plate 42, Ti having a thermal expansion coefficient of 8.9×10⁻⁶/°C close to that of the high-k film. When the High-k film is formed, the shower plate 42 can be made of, other than Ti, a material such as Mo (thermal expansion coefficient of about 4.9×10⁻⁶/°C), Ta (thermal expansion coefficient of about 6.3×10⁻⁶/°C), W (thermal expansion coefficient of about 4.3×10⁻⁶/°C) and Hastelloy (Registered Trademark) (thermal expansion coefficient of about 12.4×10⁻⁶/°C) as an Ni-based alloy.

By providing the shower plate 42 made of a material having a thermal expansion coefficient close to that of a film to be formed, it is possible to decrease the thermal expansion difference between the shower plate 42 and the film adhered to the shower plate 42 in spite of the increase in the temperature of the shower plate 42 by heating during film formation, and also possible to reduce stress generated in the film adhered to the shower plate 42. Therefore, cracks, peeling off, and separation of the film adhered to the shower plate 42 hardly occurs, and the film thickness of the film on the wafer and the stability of the in-plane film thickness distribution are improved. Furthermore, the number of particles on the wafer can be reduced.

The present embodiment has described the case in which Ti, Mo, Ta, W, or Hastelloy (Registered Trademark) as a Ni-based alloy is used as a material forming the shower plate 42 having a thermal expansion coefficient which differs less than about 5×10⁻⁶/°C from that of a film to be formed in a film forming apparatus for forming a high-k film. However, the present invention is not limited to the above, and can be applied to formation of any film as long as the shower plate 42 is made of a material having a thermal expansion coefficient that differs no more than about 5×10⁻⁶/°C from that of a film to be formed.

### (Third Embodiment)

Hereinafter, a third embodiment of the present invention will be described.

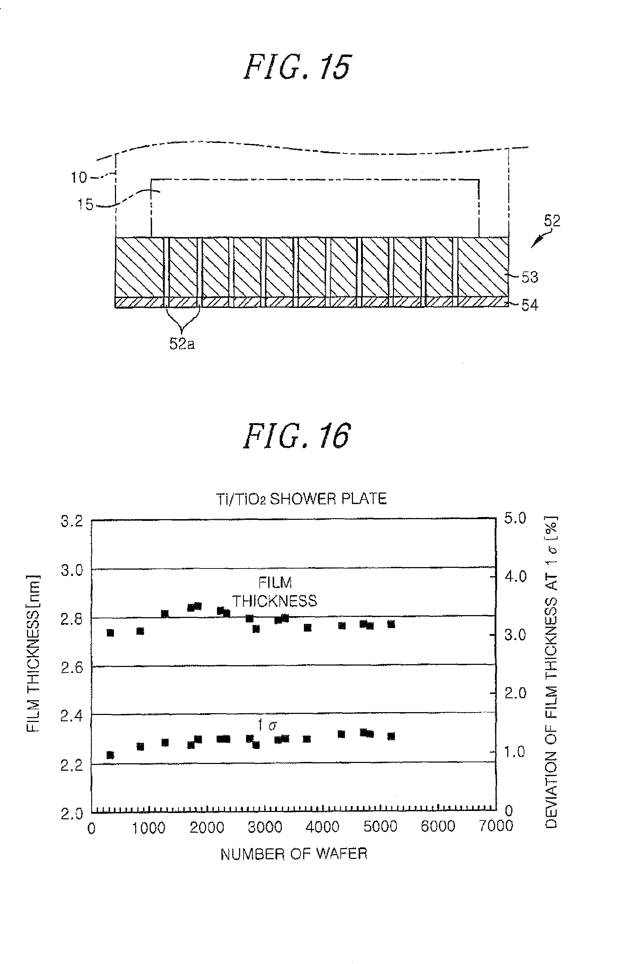

Fig. 15 is a cross sectional view showing a shower plate of a film forming apparatus in accordance with the third embodiment of the present invention. The third embodiment has the configuration same as that of the first embodiment, so that the description thereof will be omitted.

The film forming apparatus of the present embodiment forms a high-k film such as an HfSiOₓ film or an HfO₂ film. A shower plate 52 includes a main body 53, and a high-emissivity film 54 formed on a surface of the main body 53. Moreover, the shower plate 52 has a plurality of gas injection openings 52a.

The material of the main body 53 is not particularly limited. For example, it may be aluminum or aluminum alloy which has been conventionally used. Or, Ti, Mo, Ta, W, or Ni-based alloy may be used. Among them, it is preferable to use Ti, Mo, Ta, W, or Ni-based alloy.

The high-emissivity film 54 has an emissivity close to that of a film to be formed, and is made of a material having an emissivity difference of about 0.09 or less from that of the film to be formed. For example, when a film to be formed is an HfSiOₓ film or an HfO₂ film having an emissivity of about 0.9, a material having an emissivity of about 0.81 to 0.99 is used for the high-emissivity film 54. More preferably, the emissivity difference is about 0.05. At this time, when a film to be formed is an HfSiOₓ film or an HfO₂ film, the high-emissivity film 54 has an emissivity of about 0.85 to 0.95. As for a material having an emissivity of the above-described range, TiO₂ (film) can be used. The TiO₂ has an emissivity ranging from about 0.87 to about 0.94 that is within the above described range, i.e., from about 0.81 to about 0.99. As for another material forming the high-emissivity film 54, it is possible to use an Fe-based oxide (emissivity of about 0.9), a chrome-based oxide (emissivity of about 0.9), carbon (emissivity of about 0.9), and HfO₂ (emissivity of about 0.9).

The formation method is not particularly limited, and may be, e.g., deposition, anodizing or the like. When the high-emissivity film 54 is a film made of an oxide of the main body 53 material, the high-emissivity film 54 can be formed by performing an oxidation process on the main body 53. For example, when the main body 53 is made of aluminum, an anodized film (Al₂O₃) having a rough surface can be used as the high-emissivity film 54. When the main body 53 is made of Ti, the high-emissivity film 54 made of TiO₂ can be formed by performing an oxidation process on the main body 53.

The thickness of the high-emissivity film 54 ranges preferably from about 1 µm to about 50 µm at which the emissivity of the material itself can be sufficiently obtained.

Since the shower plate 52 is configured by forming on the surface of the main body 53 the high-emissivity film 54 having an emissivity that differs about 0.09 or less from that of a high-k film such as an HfSiOₓ film or an HfO₂ film, the emissivity is hardly changed even when the high-k film is adhered to the surface of the shower plate 52 by continuously performing film formation on a plurality of wafers, and the temperature increase of the shower plate 52 can be suppressed. Further, the stress generated in the high-k film by thermal expansion difference between the main body 53 and the high-k film adhered to the shower plate 52 can be extremely decreased. Hence, the generation of cracks on the high-k film adhered to the surface of the shower plate 52 can be effectively suppressed. As a consequence, the film thickness of the film on the wafer and the stability of the in-plane film thickness distribution can be improved, and the number of particles on the wafer can be reduced.

In order to more effectively suppress the generation of cracks on the high-k film, the main body 53 is preferably made of a material having a thermal expansion coefficient, measured at a film forming temperature, that differs no more than about 5×10⁻⁶/°C from that of the high-k film to be formed, e.g., Ti, Mo, Ta, W, Hastelloy (Registered Trademark), as in the case of the material of the shower plate 42 of the second embodiment. Accordingly, the initial temperature changes in the shower plate 52 and the temperature changes during film formation can be effectively suppressed, and the stress generated in the high-k film adhered to the shower plate 52 can be further decreased. Specifically, when an HfSiOₓ film or an HfO₂ film is formed, it is preferable to use Ti as a material of the main body 53 and use a TiO₂ film as the high-emissivity film. With such combination, the thermal expansion difference and the emissivity difference can be greatly reduced, and the high-emissivity film 54 can be easily formed by performing an oxidation process on the main body 53. Further, the high-emissivity film 54 is not peeled off due to tight bonding with the main body 53.

Hereinafter, the result of the test that has examined the effects of the present invention will be described.

An HfSiOₓ film was continuously formed on at least 5000 wafers while using HTB as a processing gas for film formation by a film forming apparatus including a shower plate having a TiO₂ film formed on a main body made of titanium. At this time, the film thickness changes of the HfSiOₓ film on the wafer and the variation of the film thickness changes were examined. The result thereof is shown in Fig. 16. Fig. 16 illustrates the film thickness changes of the HfSiOₓ film and the variation of the film thickness changes in the case of continuously performing film formation on at least 5000 wafers by using a film forming apparatus including a shower plate having a TiO₂ film formed on a Ti plate. As shown in Fig. 16, the film thickness was stable, and the film thickness deviation in the 5000 wafers or more was about 1.2 % at 1σ.

In the film forming apparatus for forming a High-k film of the present embodiment, the shower plate 52 includes the main body 53 and the high-emissivity film 54. In the above, there has been described an example in which TiO₂, Fe oxide, chrome-based oxide, carbon or HfO₂ is used as a material having an emissivity difference of about 0.09 or less from that of a high-k film to be formed. However, the high-emissivity film 54 may be made of any material having an emissivity difference of about 0.09 or less from that of the film to be formed without being limited to the above material.

## Claims

1. A film forming apparatus for forming a film on a surface of a substrate to be processed by having a processing gas to react on the substrate that is heated, the apparatus comprising:
a processing chamber for accommodating therein the substrate;
a mounting table for mounting thereon the substrate in the processing chamber;
a heating mechanism for heating the substrate on the mounting table;
a gas injection member, disposed to face the mounting table in the processing chamber, for injecting the processing gas toward the substrate,
wherein the gas injection member includes:
a main body having a thermal expansion coefficient, measured at a film forming temperature, higher by at least 5×10⁻⁶/°C than a thermal expansion coefficient of the film; and
an oxide coating film formed by performing oxidization process on a surface of the main body which faces the mounting table, the oxide coating film having a thickness of about 10 µm or thicker.

2. The film forming apparatus of claim 1, wherein the main body is made of aluminum or aluminum alloy, and the oxide coating film is an anodized film.

3. The film forming apparatus of claim 1, wherein the film is a high-k film.

4. The film forming apparatus of claim 3, wherein the film is selected from the group consisting of a hafnium oxide film, a hafnium silicate film, a zirconium oxide film, a zirconium silicate film, a lanthanum oxide film, a lanthanum silicate film, a tantalum oxide film, a titanic acid strontium film and a yttrium oxide film.

5. The film forming apparatus of claim 1, wherein the anodized film has a thickness of about 15 µm or more.

6. The film forming apparatus of claim 1, wherein the oxide coating film has an emissivity of about 0.6 or more.

7. The film forming apparatus of claim 1, wherein the difference between the emissivity of the oxide coating film and the emissivity of the film is about 0.1 or less.

8. The film forming apparatus of claim 7, wherein the difference between the emissivity of the oxide coating film and the emissivity of the film is about 0.09 or less.

9. A film forming apparatus for forming a film on a surface of a substrate to be processed by having a processing gas to react on the substrate that is heated, the apparatus comprising:
a processing chamber for accommodating therein the substrate;
a mounting table for mounting thereon the substrate in the processing chamber;
a heating mechanism for heating the substrate on the mounting table; and
a gas injection member, disposed to face the mounting table in the processing chamber, for injecting the processing gas toward the substrate,
wherein the gas injection member is made of a material having a thermal expansion coefficient, measured at a film formation temperature, that differs no more than about 5×10⁻⁶/°C from a thermal expansion coefficient of the film.

10. The film forming apparatus of claim 9, wherein the film is a high-k film.

11. The film forming apparatus of claim 10, wherein the film is selected from the group consisting of a hafnium oxide film, a hafnium silicate film, a zirconium oxide film, a zirconium silicate film, a lanthanum oxide film, a lanthanum silicate film, a tantalum oxide film, a titanic acid strontium film and a yttrium oxide film.

12. The film forming apparatus of claim 10, wherein the gas injection member is made of a material selected from the group consisting of Ti, Mo, Ta, W, and Hastelloy (Registered Trademark).

13. A film forming apparatus for forming a film on a surface of a substrate to be processed by having a processing gas to react on the substrate that is heated, the apparatus comprising:
a processing chamber for accommodating therein the substrate;
a mounting table for mounting thereon the substrate in the processing chamber;
a heating mechanism for heating the substrate on the mounting table;
a gas injection member, disposed to face the mounting table in the processing chamber, for injecting the processing gas toward the substrate,
wherein the gas injection member includes:
a main body; and
a coating film formed on a surface of the main body which faces the mounting table, an emissivity difference between the coating film and the film being about 0.09 or less.

14. The film forming apparatus of claim 13, wherein the film is a high-k film.

15. The film forming apparatus of claim 14, wherein the film is selected from the group consisting of a hafnium oxide film, a hafnium silicate film, a zirconium oxide film, a zirconium silicate film, a lanthanum oxide film, a lanthanum silicate film, a tantalum oxide film, a titanic acid strontium film and a yttrium oxide film.

16. The film forming apparatus of claim 15, wherein the film is a hafnium oxide film or a hafnium silicate film.

17. The film forming apparatus of claim 16, wherein the coating film has an emissivity of about 0.081 to 0.099.

18. The film forming apparatus of claim 17, wherein the coating film is made of a material selected from the group consisting of TiO₂, Fe oxide, chrome-based oxide, carbon, and hafnium oxide.

19. The film forming apparatus of claim 13, wherein the main body is made of a material having a thermal expansion coefficient, measured at a film forming temperature, that differs less than about 5×10⁻⁶/°C from a thermal expansion coefficient of the film.

20. The film forming apparatus of claim 19, wherein the gas injection member is made of a material selected from the group consisting of Ti, Mo, Ta, W, and Hastelloy (Registered Trademark).

21. The film forming apparatus of claim 13, wherein the main body is made of Ti, and the coating film is made of TiO₂.

22. A gas injection member for use in a film forming apparatus for forming a film on a surface of a substrate to be processed by having a processing gas to react on the substrate that is heated, the gas injection member being disposed to face a mounting table in a processing chamber for mounting thereon the substrate to inject a processing gas toward the substrate, the gas injection member comprising:
a main body having a thermal expansion coefficient, measured at a film forming temperature, higher by about 5×10⁻⁶/°C than a thermal expansion coefficient of the film; and
an oxide coating film formed on a surface of the main body which faces the mounting table by performing an oxidation process on the main body, the oxide coating film having a thickness of about 10 µm or above.

23. A gas injection member for use in a film forming apparatus for forming a film on a surface of a substrate to be processed by having a processing gas to react on the substrate that is heated, the gas injection member being disposed to face a mounting table in the processing chamber for mounting thereon the substrate to inject the processing gas toward the substrate,
wherein the gas injection member is made of a material having a thermal expansion coefficient, measured at a film forming temperature, that differs less than about 5×10⁻⁶/°C from a thermal expansion coefficient of the film.

24. A gas injection member for use in a film forming apparatus for forming a film on a surface of a substrate to be processed by having a processing gas to react on the substrate that is heated, the gas injection member being disposed to face a mounting table in a processing chamber for mounting thereon the substrate to inject the processing gas toward the substrate, the gas injection member comprising:
a main body; and
a coating film formed on a surface of the main body which faces the mounting table, the coating film having an emissivity difference of about 0.09 or less from an emissivity of the film.
